# EUROPÄISCHE PATENTSCHRIFT

(11) **EP 0 780 981 B1**
(45) Veröffentlichungstag und Bekanntmachung des Hinweises auf die Patenterteilung: **10.04.2002**
(21) Anmeldenummer: 96120177.9
(22) Anmeldetag: 13.12.1996
(51) Int. Cl.: H03K 17/96, H03K 17/94

(54) **Auswerteelektronik für ein Berührungs-Sensorelement**
Evaluation circuit for a touch sensor
Circuit d'évaluation pour un capteur à effleurement

(30) Priorität: 19.12.1995 DE 19547342
(43) Veröffentlichungstag der Anmeldung: 25.06.1997
(73) Patentinhaber: Diehl Stiftung & Co., 90478 Nürnberg (DE)
(72) Erfinder: Fluhrer, Henry, 90489 Nürnberg (DE); Hammelsbacher, Karlheinz, 91126 Schwabach (DE)

(56) Entgegenhaltungen:
- DE-A- 3 723 566
- US-A- 5 103 085
- US-A- 5 371 359

## Beschreibung

Die Erfindung betrifft eine Auswerteelektronik für das Ausgangssignal eines auf Berührung ansprechenden Sensorelements, wobei die Auswerteelektronik den Signalpegel des Ausgangssignals erfaßt und mit einem Schwellwert vergleicht und wobei in der Auswerteelektronik wenigstens ein Zeitfenster vorgegeben ist und die Auswerteelektronik ein Schaltsignal abgibt, wenn der Signalpegel mit dem Schwellwert während des Zeitfensters vorlag.

Die Funktionen von Haushaltsgeräten oder Geräten der Unterhaltungselektronik lassen sich mittels Berührungssensoren, wie Infrarotsensor oder kapazitiver Sensor, steuern. Ein kapazitiver Sensor ist in der DE 38 44 392 A1 beschrieben. Bei einem Kochherd mit einer Glaskeramikplatte können die Sensorelemente mit der Glaskeramikplatte integriert sein.

Das bei Berührung am Sensorelement auftretende Ausgangssignal wird gewöhnlich über eine Auswerteelektronik erfaßt, die einen Schwellwert für den Signalpegel vorgibt. Erreicht der Signalpegel des Ausgangssignals den Schwellwert, dann gibt die Auswerteelektronik sofort ein Schaltsignal weiter; andernfalls gibt sie kein Schaltsignal weiter. Eine solche Schaltung ist zwar einfach, hat jedoch den Nachteil, daß, wenn sich beispielsweise durch Verschmutzen oder andere Einflüsse das Ansprechverhalten des Sensorelements ändert, der Schwellwert bei Berührung möglicherweise nicht mehr erreicht wird, also trotz Betätigung kein Schaltsignal auftritt.

Aus DE OS 3723 566 A1 ist ein Näherungsschalter bekannt, in bevorzugter Ausgestaltung mit einem passiven Infrarotsensor arbeitend, der Maßnahmen vorsieht um Fehlauslösungen zu verhindern, die infolge elektrischer Störungen heim Schalten von induktiven Verbrauchern auftreten und zwar hauptsächlich zwischen dem Ausgang des Schwellwertschalters und dem Eingang der Auswerteelektronik. Das weiterzuverarbeitende Ausgangssignal des Sensors wird zunächst über einen Schwellwertschalter geführt, von dessen Ausgang führt ein Signalweg direkt auf ein UND Gatter und ein zweiter Signalweg über ein Verzögerungsglied ebenfalls zum UND-Gatter, hier erfolgt eine **einzige** logische UND-Abfrage, nämlich ob vor der eigentlichen Schaltstufe ein Störsignal anliegen kann. Dies ist hier immer dann der Fall, wenn die Dauer eines anliegenden Signals kürzer ist, als die Verzögerungszeit des Verzögerungsgliedes, die jeweils nur mit einem **einzigen** Wert fest einstellbar ist. Nachteilig an dieser bekannten Anordnung ist zum einen, daß Störsignale von nur unmerklich längerer Dauer als der fest eingestellten Verzögerungszeit weiterhin Fehlfunktionen auslösen. Zum zweiten ist eine denkbare Verlängerung der Verzögerungszeit zumindest durch die Dauer von tatsächlich anliegenden Schaltsignale nach oben begrenzt , d.h. eine beliebig denkbare Verlängerung der Verzögerungszeit, ist ab einer gewissen Zeitdauer nicht mehr sinnvoll möglich, da die eingestellte Verzögerungszeit, immer kürzer vorgegeben sein muß als die Dauer des Anliegens eines Signals, welches tatsächlich den Schaltvorgang auslösen soll . Drittens bewirkt ein Schaltsignal, welches sofort mit der nötigen Signalhöhe zur Überwindung des Schwellwertes ansteht und welches kein Störsignal ist, eine gewisse Benulzerunfreundlichkeit, denn insbesondere bei menügeführten Steuerungen, die eine häufige nacheinander folgende Betätigung des Sensors erfordert, ist zu erwarten, daß der Benutzer zumindest auf eine Geduldsprobe gestellt wird, denn der Sensor muß jedesmal über die eingestellte Verzögerungszeit hinweg berührt werden. Viertens kommt diese Lösung der beanspruchten Erfindung nicht nahe, da sie sich ausschließlich auf Behebung von elektrischen Störungen beschränkt und weiteren o.g. Störungen , wie sie zum Beispiel durch Fettbelag auf dem Sensor auftreten können, keine Beachtung schenkt. Grundsätzlich läßt die bekannte Lösung auch alle Störungen außer Betracht, die zum Beispiel vor dem Ausgang des Schwellwertschalters und/oder anderen Orts lokalisiert sind, insbesondere zeigt sie keine Lösung auf, wie Schaltsignale, die ausgelöst worden sind, aber aus unterschiedlichsten Gründen den vorgegebenen Schwellwert nicht erreicht haben, behandelt werden und somit, obwohl beabsichtigt, nicht zum Auslösen des Schaltvorganges führen. Somit trägt die bekannte Lösung auch in der Gesamtschau nichts zu der beanspruchten Erfindung bei.

Aus US 5 103 085 ist ein photoelektrischer Detektor und Näherungsschalter vom Typus eines Reflektionsnäherungsschalters bekannt, der die Berührung eines menschlichen Fingers von Streustrahlung in einer Vielzahl von Umgebungen unterscheidet, wobei vom detektierten Signal zunächst fremde Signale (d.h. Störsignale), welche ständig mit einem Grundwert anliegen, um diesen Grundwert vermindert werden, bevor das verrninderte Detektionssignal verstärkt wird und schließlich einen vorgegebenen Schwellwert überwinden muß. Diese bekannte Lösung kommt der erfindungsgemäßen Lösung nicht nahe, da in ihr kein Hinweis enthalten ist, wie eine Auswerteelektronik auszulegen ist, die auch bei betriebsbedingten Änderungen im Ansprechverhalten des Sensorelements bei Berührung ein Schaltsignal erzeugt. Das Signal des Sensorelements durchläuft nämlich nicht vor der Durchschaltung zur Schaltelektronik eine Auswerteelektronik, die aus einer Kombination mehrerer entsprechend gewählter verschiedenen Schwellwerte und diesen entsprechend zugeordneten Zeit-Fenstern bei anschließend vorzugsweise logischer ODER-Abfrage besteht.

Aufgabe der Erfindung ist es, eine Auswerteelektronik vorzuschlagen, die auch bei betriebsbedingt auftretenden Änderungen des Ansprechverhaltens des Sensorelements bei Berührung das Schaltsignal erzeugt.

Erfindungsgemäß ist obige Aufgabe dadurch gelöst, daß in der Auswerteelektronik mehrere unterschiedlich hohe Schwellwerte für den Signalpegel und diesen zugeordnete verschieden lange Zeitfenster vorgegeben sind und die Schaltelektronik das Schaltsignal abgibt, wenn der jeweilige Signalpegel des Ausgangssignals einen der Schwellwerte erreicht und während des diesem zugeordneten Zeitfensters vorlag, wobei höheren Schwellwerten kürzere Zeitfenster und niedrigeren Schwellwerten längere Zeitfenster zugeordnet sind.

Dadurch ist erreicht, daß das Auftreten des Schaltsignals bei der Berührung des Sensors nicht mehr nur vom Erreichen des Schwellwerts des Signalpegels, sondern auch von dessen Dauer abhängt. Ein erniedrigter Signalpegel des Ausgangssignals kann sich beispielsweise durch Verschmutzung oder sonstige Umwelteinflüsse, wie Fettschicht, Temperatur, Streulicht und/oder Alterung, ergeben. Auch bei einem erniedrigten Signalpegel tritt das Schaltsignal auf, wenn er über eine gewisse Zeit (Zeitfenster) gleichmäßig anliegt, also der Benutzer den Sensor entsprechend lang berührt. Eine Berührung, die kürzer als das Zeitfenster ist, beispielsweise durch eine Fliege erfolgt, führt nicht zum Schaltsignal.

Es ist also nicht erforderlich, von Anfang an das Ausgangssignal so hoch auszulegen, das es auch bei Verschmutzung oder ähnlichem noch zum Erreichen des Schwellwerts ausreicht. Dies ist günstig, weil bei einem sehr hoch ausgelegten Ausgangssignal im ungestörten Fall eine unerwünschte Überempfindlichkeit des Sensors gegeben wäre. Durch die Auswerteelektronik wird ein sich im Betrieb änderndes Reflektionsverhalten (bei einem Infrarotsensor) im Endergebnis kompensiert.

In der Auswerteelektronik sind mehrere unterschiedlich hohe Schwellwerte für den Signalpegel und diesen zugeordnete verschieden lange Zeitfenster vorgegeben. Die Auswerteelektronik gibt das Schaltsignal ab, wenn der jeweilige Signalpegel des Ausgangssignals einen der Schwellwerte erreicht und während des diesem zugeordnetem Zeitfensters vorlag. Vorzugsweise sind höheren Schwellwerten kürzere Zeitfenster und niedrigeren Schwellwerten längere Zeitfenster zugeordnet.

Dadurch ist erreicht, daß die Auswerteelektronik bei gutem Ansprechverhalten, bei Infrarotsensoren speziell gutem Reflektionsverhalten, schon nach kurzer Berührung, jedoch nicht überempfindlich, und bei schlechtem Ansprechverhalten bzw. Reflexionsverhalten, nach einer etwas längeren Berührung anspricht. Der Benutzer wird eine gegebenenfalls notwendige längere Berührung ohne weiteres Nachdenken vornehmen, wenn die gewünschte Funktion nicht schon nach kurzer Berührung geschaltet wird.

In besonders bevorzugter Ausgestaltung der Erfindung liegt das Ausgangssignal des Sensors parallel an n-Komperatoren an die jeweils ein unterschiedlich großer Schwellwert gelegt ist. In Reihe ist den Komperatoren jeweils ein Verzögerungsglied nachgeschaltet, deren Verzögerungszeit unterschiedlich lang einstellbar ist und die genannten Zeitfenster bildet. Hinsichtlich o.g. Zuordnung von Signalpegel und Signaldauer, werden bevorzugt höheren Schwellwerten kürzere Zeitfenster und niedrigeren Schwellwerten längere Zeitfenster zugeordnet. Alle Verzögerungsglieder sind mit einer Logischen Einheit, hier vorzugsweise durch ein ODER Gatter realisiert, verbunden. Das Ausgangssignal des Sensors wird also über das jeweilige Zeitfenster geführt dessen vorgeschalteten Schwellwert es zunächst erreicht hat und wenn es mit der entsprechend vorgegebenen Dauer, bestimmt durch die entsprechend eingestellte Verzögerungszeit, anlag, wird nach der logischen Abfrage letztendlich das Schaltsignal abgegeben. Andernfalls, d.h. ein Ausgangssignal erreicht entweder nicht den Signalpegel eines oder aller Schwellwerte(s) oder/und liegt nicht mit entsprechender Dauer an, erfolgt keine Auslösung des Schaltsignals.

Weitere vorteilhafte Ausgestaltungen der Erfindung ergeben sich aus dem Unteranspruch und der folgenden Beschreibung eines Ausführungsbeispiels. In der Zeichnung zeigen:
Figur 1 ein Sensorelement mit Auswerteelektronik,
Figur 2 ein Prinzipschaltbild einer Auswerteelektronik,
Figur 3 ein Zeitdiagramm,
Figur 4 ein speziell ausgebildetes Sensorelement.

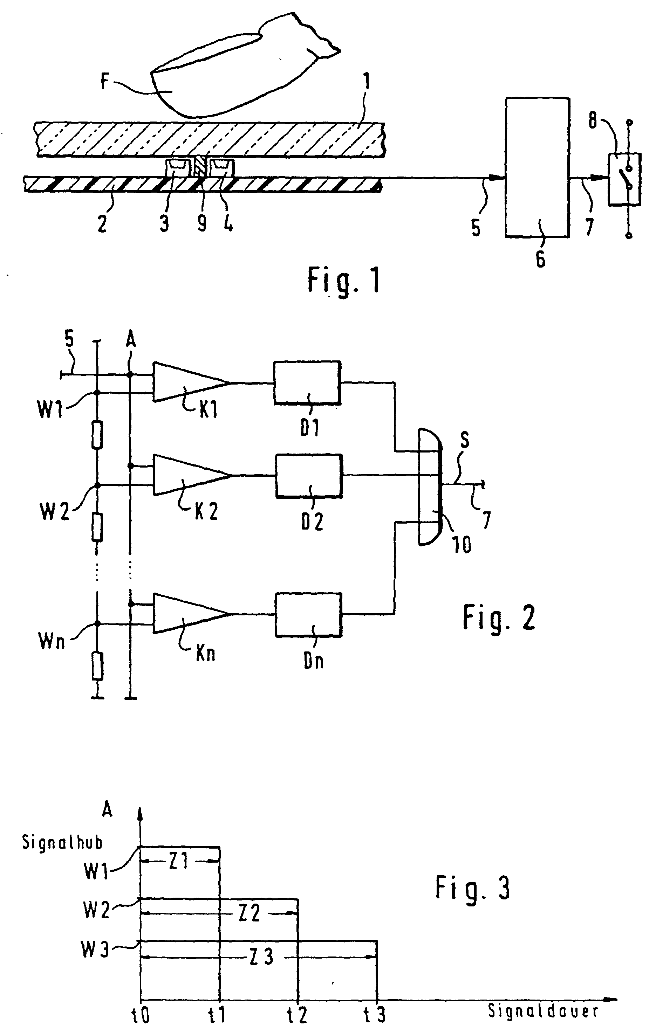

Unter einer Tastenzone einer Glaskeramikplatte (1) eines Kochherdes ist eine Leiterplatte(2) angeordnet. Im übrigen liegen unter der Glaskeramikplatte (1) Strahlungsheizkörper. Auf die Leiterplatte (2) sind mehrere Paare - von denen in Figur 1 eines gezeigt ist- von Infrarot-Sendedioden (3) und Empfangsdioden (4) bzw. Empfangs-Phototransistoren in SMD-Technik aufgelötet.

Diese befinden sich in TOPLED-Gehäusen, welche zur automatischen Bestückung und Verlötung auf der Oberfläche der Leiterplatte (2) geeignet sind. Die Sendediode (3) strahlt ein Infrarotsignal durch die Glaskeramikplatte (1) das durch einen Finger (F) auf die Empfangsdiode (4) reflektierbar ist. Geschieht dies, dann wird über eine Leitung (5) ein Ausgangssignal mit einem gewissen Signalpegel an die Auswerteelektronik, (6) geleitet, die gegebenenfalls an einer Leitung (7) ein Schaltsignal zu einer Schaltelektronik (8) leitet, was im Endergebnis gegebenen falls zu einer weiteren Signalverarbeitung für das Schalten eines des Strahlungsheizkörpers führt.

Um ein direktes Übersprechen zwischen der Sendediode (3) und der Empfangsdiode (4) zu vermeiden, ist zwischen diesen ein Abschirmblech (9) angeordnet, das ebenfalls auf die Leiterplatte (2) aufgelötet ist. Das Abschirmblech (9) erlaubt es, die Sendediode (3) und die Empfangsdiode (4) sehr nahe beieinander anzuordnen, was einerseits die Signalausbeute erhöht und andererseits kleine Abmessungen des Sensors bzw. Tastenfeldes auf der Glaskeramikplatte (1) gestattet.

Figur 2 zeigt ein Prinzipschaltbild der Auswerteelektronik (6). Das über die Leitung (5) anliegende Ausgangssignal (a) liegt parallel an n - Komparatoren (K1, K2 ... Kn) . Außerdem sind an die Komparatoren (K1 bis Kn) unterschiedliche Schwellwerte (W1 bis Wn), insbesondere Spannungsschwellwerte, gelegt. Ausgangsseitig ist jedem Komperator (K1 bis Kn) ein Verzögerungsglied (D1, D2 ... Dn) gelegt. Jedes Verzögerungsglied (D1 bis Dn) führt zu einer anderen Schalt-Verzögerungszeit und schafft dadurch die genannten Zeitfenster. Ist der Schwellwert (W1) der größte der abgestuften Schwellwerte, dann ist das vom Verzögerungsglied (D1) geschaffenen Zeitfenster das kürzeste. Entsprechend ist dann der Schwellwert (Wn) der kleinste der Schwellwerte und die Verzögerungszeit des Verzögerungsgliedes (Dn) die längste.
Die Verzögerungsglieder (D1,D2...Dn) liegen an einem ODER-Gatter (10). An dessen Ausgang tritt gegebenenfalls das Schaltsignal (s) für die Leitung (7) auf.

Die Auswerteelektronik (6) kann in einem für die Regelung bzw. Steuerung des Kochherdes ohnehin vorgesehenen Mikrocontroller verwirklicht sein.

Die Funktionsweise wird anhand von Figur 3 beschrieben.
Es sind dort die Schwellwerte (W1, W2, W3) mit ihren zugeordneten Zeitfenstem (Z1,Z2,Z3) dargestellt.

Wird zum Zeitpunkt (t0) der Finger (F) über die Sendediode (3) und die Empfangsdiode (4) auf die Glaskeramikplatte (1) gelegt und erreicht dadurch der Signalpegel des Ausgangssignals (A) den hohen Schwellwert (W1) und bleibt er bis zum Ende des Zeitfensters (Z1) bestehen, dann tritt das Schaltsignal (s) zum Zeitpunkt (t1) auf. Es besteht also eine gewisse, kurze Schaltverzögerung (t1 - t0).

Erreicht das Ausgangssignal (a) nur den mittleren Schwellwert (W2) und bleibt es während des längeren Zeitfensters (Z2) bestehen, dann tritt das Schaltsignal (s) zum Zeitpunkt (t2), also mit einer längeren Verzögerungszeit (t2-t0) auf.

Erreicht der Signalpegel des Ausgangssignals (a) nur den kleinen Schwellwert (W3), beispielsweise weil die Oberfläche der Glaskeramikplatte (1) verschmutzt ist, und bleibt dieses Ausgangssignal während des langen Zeitfensters (Z3) bestehen, dann tritt das Schaltsignal (s) zum Zeitpunkt (t3), also mit noch längerer Verzögerungszeit (t3-t0) auf. Für den Benutzer hat dies den Vorteil, daß er auch bei einer verschmutzten Glaskeramikplatte (1) das Schaltsignal auslösen kann, wenn er das Sensorelement entsprechend länger betätigt. Dies wird er ohne Nachdenken tun, wenn der gewünschte Schaltvorgang nicht schon nach der Vcrzögerungszeit (t1-t0) oder der Verzögerungszeit (t2-t0) ausgelöst wurde.

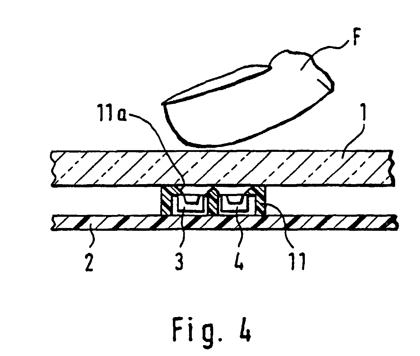

Durch ein Sensorelement nach Figur 4 ist eine weitere noch verbesserte Auswertbarkeit gegen Umgebungseinflüsse gegeben, nämlich gegen Fremdlicht, insbesondere Sonnenlicht. Das Gehäuse (11), in dem die Empfangssensoren (4) untergebracht sind, weist konische Wände (11a) im Lichteinfallstrichter auf. Dadurch wird Störlicht von der Seite weitgehend ausgeblendet.

## Patentansprüche

1. Auswerteelektronik für das Ausgangssignal eines auf Berührung ansprechenden Sensorelements, wobei die Auswerteelektronik den Signalpegel des Ausgangssignals erfaßt und mit einem Schwellwert vergleicht und wobei in der Auswerteelektronik (6) wenigstens ein Zeitfenster (Z1) vorgegeben ist und die Auswerteelektronik (6) ein Schaltsignal (S) abgibt, wenn der Signalpegel mit dem Schwellwert (W1) während des Zeitfensters (Z1) vorlag,
**dadurch gekennzeichnet,**
**daß** in der Auswerteelektronik (6) mehrere unterschiedlich hohe Schwellwerte (W1,W1...Wn) für den Signalpegel und diesen zugeordnete verschieden lange Zeitfenster (Z1,Z2...Zn) vorgegeben sind und die Auswerteelektronik (6) das Schaltsignal (S) abgibt, wenn der jeweilige Signalpegel des Ausgangssignals (A) einen der Schwellwerte erreicht und während des diesem zugeordneten Zeitfensters vorlag, wobei höheren Schwellwerten kürzere Zeitfenster und niedrigeren Schwellwerten längere Zeitfenster zugeordnet sind.

2. Auswerteelektronik nach Anspruch 1,
**dadurch gekennzeichnet,**
**daß** das Ausgangssignal (A) an Komparatoren (K1,K2,Kn) liegt, an die jeweils einer der Schwellwerte (W1,W2,Wn), gelegt ist, daß den Komparatoren Verzögerungsglieder (D1,D2...Dn) nachgeschaltet sind, die über ein ODER-Gatter (10) das Schaltsignal (S) abgeben.

3. Sensorelement mit einer Auswerteelektronik nach Anspruch 1 oder 2,
**dadurch gekennzeichnet,**
**daß** das Sensorelement ein Sende- (3) und ein Empfangselement (4) aufweist und daß zumindest das Empfangselement (4) in einem Gehäuse (11) untergebracht ist, welches einen Lichteinfallstrichter mit konisch zum Sensor hin zulaufenden Wänden (11a) aufweist.

## Claims

1. Evaluating electronics for the output signal of a sensor element which responds to touch, in which the evaluating electronics determine the signal level of the output signal and compare it with a threshold value and at least one time window (Z1) is preset in the evaluating electronics (6) and the evaluating electronics (6) emit a switch signal (S) when the signal level with the threshold value (W1) is present during the time window (Z1),
**characterized in that**,
in the evaluating electronics (6), a plurality of different threshold values (W1, W2...Wn) for the signal level, and time windows (Z1, Z2...Zn) of different lengths associated with these threshold values are preset and the evaluating electronics (6) emit the switch signal (S) when the actual signal level of the output signal (A) reaches one of the threshold values and is present during the time window associated with said threshold value, higher threshold values being associated with shorter time windows and lower threshold values being associated with longer time windows.

2. Evaluating electronics according to Claim 1,
**characterized in that**
the output signal (A) is applied to comparators (K1, K2, Kn), to each of which one of the threshold values (W1, W2, Wn) is applied, and **in that** on the output side of the comparators delay elements (D1, D2... Dn) are connected which emit the switch signal (S) by way of an OR-gate (10).

3. Sensor element having evaluating electronics according to Claim 1 or 2,
**characterized in that**
the sensor element has a transmitting element (3) and a receiving element (4) and **in that** at least the receiving element (4) is accommodated in a housing (11) which has a light-incidence funnel with walls (1 1a) tapering towards the sensor.

## Revendications

1. Electronique d'exploitation pour le signal de sortie d'un élément de capteur réagissant au contact, l'électronique d'exploitation détectant le niveau du signal de sortie et le comparant à une valeur seuil, et dans l'électronique d'exploitation (6) étant prédéterminée au moins une fenêtre de temps (Z1), et l'électronique d'exploitation (6) délivrant un signal de commutation (S) lorsque le niveau du signal avait la valeur seuil (W1) pendant la fenêtre de temps (Z1), **caractérisée en ce que** dans l'électronique d'exploitation (6) sont prédéterminées plusieurs valeurs seuils (W1, W2... Wn) de hauteurs différentes pour le niveau du signal ainsi que des fenêtres de temps (Z1, Z2.... Zn) de longueurs différentes associées à celles-ci, et l'électronique d'exploitation (6) délivre le signal de commutation (S) lorsque le niveau respectif du signal de sortie (A) atteint l'une des valeurs seuils et s'est manifesté avec la valeur seuil (W1) pendant la fenêtre de temps (Z1) associée à celle-ci, des valeurs seuils plus élevées étant affectées à des fenêtres de temps plus courtes et des valeurs seuils plus basses à des fenêtres de temps plus longues.

2. Electronique d'exploitation selon la revendication 1, **caractérisée en ce que** le signal de sortie (A) s'applique à des comparateurs (K1, K2, Kn) à chacun desquels a été appliquée l'une des valeurs seuils (W1, W2, Wn), **en ce que** derrière les comparateurs sont montés des organes de temporisation (D1, D2... Dn) qui délivrent le signal de commutation (S) par une porte OU (10).

3. Elément de capteur comportant une électronique d'exploitation selon la revendication 1 ou 2, **caractérisé en ce que** l'élément de capteur comporte un élément émetteur (3) et un élément récepteur (4) et **en ce qu'**au moins l'élément récepteur (4) est logé dans un boîtier (11) qui comporte un cône d'entrée de lumière avec des parois (1 la) qui se terminent coniquement en direction du capteur.
